Europäisches Patentamt

European Patent Office

Office européen des brevets

(19)

(11) Publication number: **0 225 570**
**A2**

(12) **EUROPEAN PATENT APPLICATION**

(21) Application number: **86116621.3**

(22) Date of filing: **29.11.86**

(51) Int. Cl.⁴: **B 26 F 3/12, G 03 F 7/16**

(30) Priority: **03.12.85 DE 3542658**

(43) Date of publication of application: **16.06.87**
**Bulletin 87/25**

(84) Designated Contracting States: **CH FR GB IT LI NL SE**

(71) Applicant: **E.I. DU PONT DE NEMOURS AND COMPANY,**
**1007 Market Street, Wilmington Delaware 19898 (US)**

(72) Inventor: **Hahn, Jochem, Kurlandstrasse 26,**
**D-7407 Ergenzingen (DE)**
Inventor: **Kricke, Thomas, Spitalgasse 13, D-7252 Weil**
**der Stadt (DE)**
Inventor: **Veihelmann, Traugott, Schulstrasse 23,**
**D-7036 Schönaich (DE)**
Inventor: **Härdter, Otto, Holzbronnerstrasse 5,**
**D-7260 Calw-Stammheim (DE)**
Inventor: **Tamm, Wilhelm, Gelshalde 2, 7031 Deufringen**
**(DE)**
Inventor: **Ott, Albert, Mörikestrasse 41,**
**D-7311 Bissingen a.d. Teck (DE)**
Inventor: **Dippon, Siegfried, Roseggerstrasse 12,**
**D-7268 Gechingen (DE)**

(74) Representative: **von Kreisler, Alek, Dipl.-Chem. et al,**
**Deichmannhaus am Hauptbahnhof, D-5000 Köln 1 (DE)**

(54) **Process for thermal separation of a two-layer or multilayer film.**

(57) In the process for thermal separation of a two-layer or multilayer film, a wire is placed on the film and heated with a pulsed heating current to evaporate the film, whereby the heating power is located above the heating power permissible with continuous heating. The heating current is switched off before reaching the melting temperature of the hot wire. The process makes possible the separation of multilayer films, especially of dry resist films for the preparation of circuit boards, without joining the layers of film with one another in the separation process and without carbonization, thickening or particle separation at the plate of separation. An arrangement for carrying out the process has a heated wire and a triggering arrangement for pulse heating of the hot wire. The hot wire can be heated especially by alternating current.

## TITLE
## AX-0139

## PROCESS FOR THERMAL SEPARATION OF
## A TWO-LAYER OR MULTILAYER FILM

### BACKGROUND OF THE INVENTION

The invention relates to a process for the thermal separation of a two-layer or multilayer film and an apparatus for carrying out the process.

In the prior art there are the known arrangements for sealing plastic bags for household use. In such cases, two plastic or film layers laying on top of one another are separated from a projecting edge by a hot wire and are welded together. The hot wire is a part of a clamping arrangement for the layers of film which wire is applied to the film layers cold and then is heated by a heating current, which flows via a switch switched through activation of the clamping arrangement. The heating process is ended by opening the clamping arrangement by the operator, and its duration must be determined by tests on the properties of the bag being closed.

Contrary to prior art processes which seal the film layers, the subject of the invention is to provide a process for thermal separation of a two-layer or multilayer film in which the individual film layers are not combined with one another.

### SUMMARY OF THE INVENTION

The present invention is directed to a process for the thermal separation of a multilayer film containing at least two layers by means of a hot wire, whereby a wire to be heated is placed on the film in a cold state and a current is applied to flow through the wire to produce heat in the wire placed in contact with the film, characterized in that

2

heating current for separating layers of the film is produced without simultaneously joining the layers with one another as a current pulse with a current strength is produced such that during the period of the current pulse the heating power converted in the heated wire is greater than the greatest heating power permissible with continuous heating, and that the duration of the current pulse is limited so that the heated wire is heated sufficiently to evaporate film material without fusing the film layers together. Also the present invention is directed to apparatus for carrying out the disclosed process.

BRIEF DESCRIPTION OF DRAWINGS

Figure 1 shows in schematic form a separating arrangement with pulse-heated heating wire for separating a two-layer or multilayer film.

Figure 2, as a block wiring diagram, shows a triggering arrangement for the pulse heating of the heated wire shown in Figure 1.

Figure 3 shows a detailed wiring diagram for the control circuit shown in Figure 2.

Figure 4 shows in a schematic representation elements of an apparatus for rolling dry resist film onto circuit boards.

Figure 5 shows an operating step of the arrangement shown in Figure 4.

Figures 6-7 show the interaction of the individual elements in the apparatus according to Figure 4 in the lamination of a circuit board.

DETAILED DESCRIPTION OF THE INVENTION

It has been found that with heating according to the present invention with a heating wire temperature located above the temperature permitted with continuous heating with a very rapidly input (heat-up time typically less than 100 ms), the hot wire can be brought to a high value such that the film to be separated is evaporated without the layers of a film joining with one another. A melting through of the hot wire is prevented by limiting the time of heating.

The process is especially suitable for cutting a film consisting of a support layer and a photoresist layer. Such films are used in the photochemical preparation of printed circuit boards for electronics for coating the circuit boards with photoresist (photosensitive resist). The resist film, protected on one side by the supporting film is laminated onto the printed circuit board, the resist film is exposed following the lamination process and thereafter the supporting film is pulled away from the resist film, so that, through subsequent development of the resist film, a conducting pathway pattern can be prepared by etching out.

The laminating process is carried out on individual circuit board parts, whereby the resist film is cut from a larger supply roll. In the laminating processes known so far, the cutting took place through a rotating round knife, because the properties of the photoresist are impaired particularly due to polymerization through excessive action of heat, and because the protecting film must later be pulled off of the resist film, so that a combining of the film layers with one another through the separation is to be avoided. It has been found that the thermal impairment of the resist in the separation process according to the invention, due to the short time of heating, is minimal and also, surprisingly, that after the thermal separation of the film the protecting film can be pulled away from the resist film without difficulties. Also, no carbonization appears at the place of separation, and the separation edge does not melt or shrink to form a thickened edge as in the known processes.

It is found to be of practical advantage in the process according to the invention that the time required for the cutting process is very small, so that the throughput is increased with separation of the film. Also, in contrast to the mechanical separations, in the thermal separation substantially no protective film or resist film spangles or flakes result which can contaminate the laminating arrangement and can be possibly introduced under the resist film in the circuit board being processed or subsequent ones. This is especially advantageous for the preparation of circuit boards with high pathway density, because the yield of satisfactory pieces can be raised substantially by the claimed process.

An especially advantageous embodiment of the process according to the invention is in the mode of heating, namely application of alternating current substantially for the duration of a whole-numbered multiple of its half-period duration. Any switching on can always take place at a no-voltage point and switching off can always take place at a no-current point, so that the switching is accomplished without power.

The invention is explained in more detail in the following with reference to the attached drawings by means of an embodiment example.

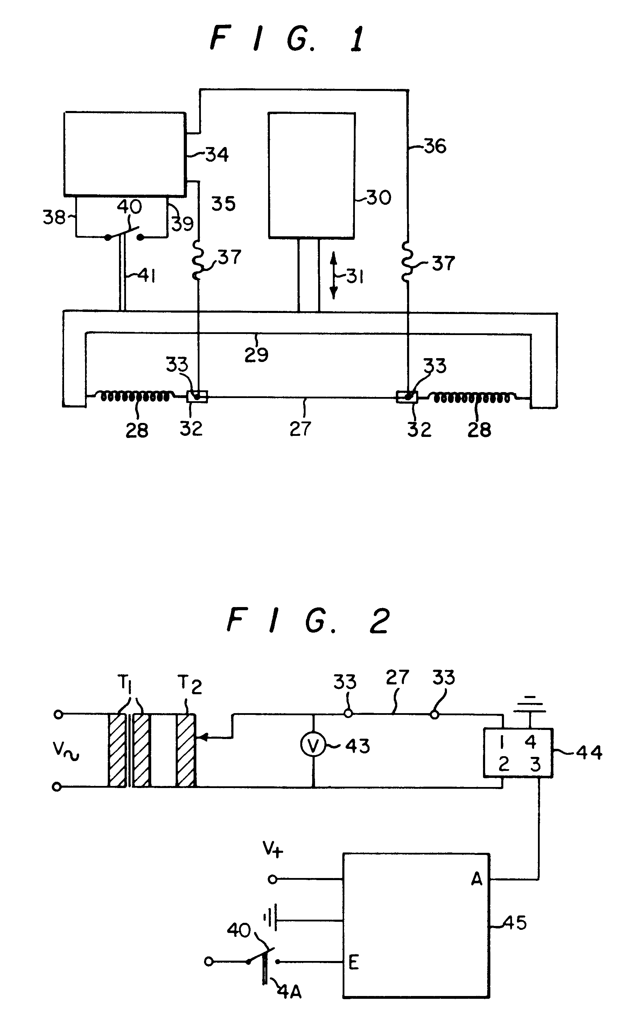

Figure 1 shows in schematic form a separating apparatus with pulse-heated heating wire for separating a two-layer or multilayer film. A heating wire 27 is clamped in a support 29 by means of spring elements 28, which support can be moved up and down by means of a moving arrangement 30, as is indicated by the arrow 31. The spring elements 28 and the moving arrangement 30 can be any hydraulic, pneumatic, electromechanical or other suitable mechanisms of known type and are not described here in detail. In the practical design of the separating apparatus, the arrangement according to Figure 1 is applied in such a way that the heated wire 27 extends over the film (not shown) to be separated and can be applied thereto over its entire width by means of the moving arrangement 30. An example of a hot wire material is Cronix 80 extra, material no. 2,4869 (ASTM/ASME B344) with a diameter of 0.2 mm and a length of 660 mm. Depending on the field of use, other known materials are also suitable for heated wires.

The heated wire 27 is attached at fastening points 33 to insulating bodies 32 for electrical insulation from the spring elements 28. The triggering arrangement 34 serves to supply the heated wire 27 via connecting wires 35 and 36, which have flexible sections 37, with a heating current for the heating. The triggering arrangement 34 is connected with a switch 40 via leads 38 and 39, which is activated by movement of the support 29, as indicated at 41. On activation of the switch 40, the heating current is switched on through the heating wire 27. The switch 40 is attached in such a way that it is activated when the unheated heating wire 27 is applied to the film to be cut and can, for example, be a snap-action switch (microswitch).

The triggering arrangement 34 applies the heating current as a short pulse with a current strength such that the heating wire 27 is heated jump-wise to a temperature sufficient for evaporating the film material. The power converted by the heating current in the heating wire exceeds the maximum permissible heating power with continuous heating, so that the heating up must take place as fast as possible. With continuous heating, accordingly, the heating wire would melt, but the duration of the heating current pulse is set so short that the heating current is switched off before the heating wire 27 melts.

Figure 2 shows a block wiring diagram of the triggering arrangement 34 for the heating wire 27. The heating wire is connected via connection terminals 42 with the triggering arrangement. The triggering arrangement consists of an isolating transformer $T_1$ with subsequent regulating transformer $T_2$ in a saver circuit for isolation from the supply network and for regulating a variable voltage to the heating current supply. The voltage set can be read on a voltmeter 43. The heating current through the heating wire 27 is controlled by an electronic relay 44. The relay 44 is a commercially obtainable relay on semiconductor basis with galvanic separation between control circuit and switching circuit.

The current flow through the heating wire is switched on by means of a triac (essentially two thyristors connected antiparallel) connected to the relay 44 between the terminals 1 and 2. The triac is fired when, after applying a control voltage between the entrance terminals 3 and 4, the next passage through zero of the alternating voltage applied to the relay 44 takes place; the firing is accomplished by a no-passage detector for the alternating voltage, which is activated by the control voltage. The flow of current between the terminals 1 and 2 of the relay is maintained until the control voltage is applied to the terminals 3 and 4, and, after switching off the control voltage, is maintained up to the next no-current passage of the alternating current. Accordingly, a whole number of half-waves of the alternating current serving as supply always flows through the heating wire 27.

The control voltage for the terminals 3 and 4 of the electronic relay 44, is produced by a control circuit 45. An input E of the control circuit 45 receives control voltage via the switch 40 (see Figure 1), when the cold cutting wire 27 is lying on the film to be separated. Through this, a timing circuit is initiated in the control circuit 45, so that the control circuit 45 at the output A gives an adjustable time control voltage to the electronic relay 44.

The heating power converted in the heating wire 27 is determined from the voltage set, readable on the measuring instrument 43, and the resistance of the heating wire known from the properties of the material. The power is to be selected so that the heating wire is heated as fast as possible for evaporation of the film material. For this purpose, the power is set at a value which would lead to melting of the heating wire with continuous operation, and the control circuit 45 is set so that the heating current is switched off before the melting point of the heating wire is reached. In this manner, the heating wire is heated up very rapidly, the film to be separated is evaporated and is separated thereby, without the films joining one another such as by fusion.

In the separation of two-layer films consisting of a protecting film and a dry resist

8

film, it has been found that through the short length of the heating pulse, the zone of change of the resist through thermal action, remains very narrow in the vicinity of the place of separation.

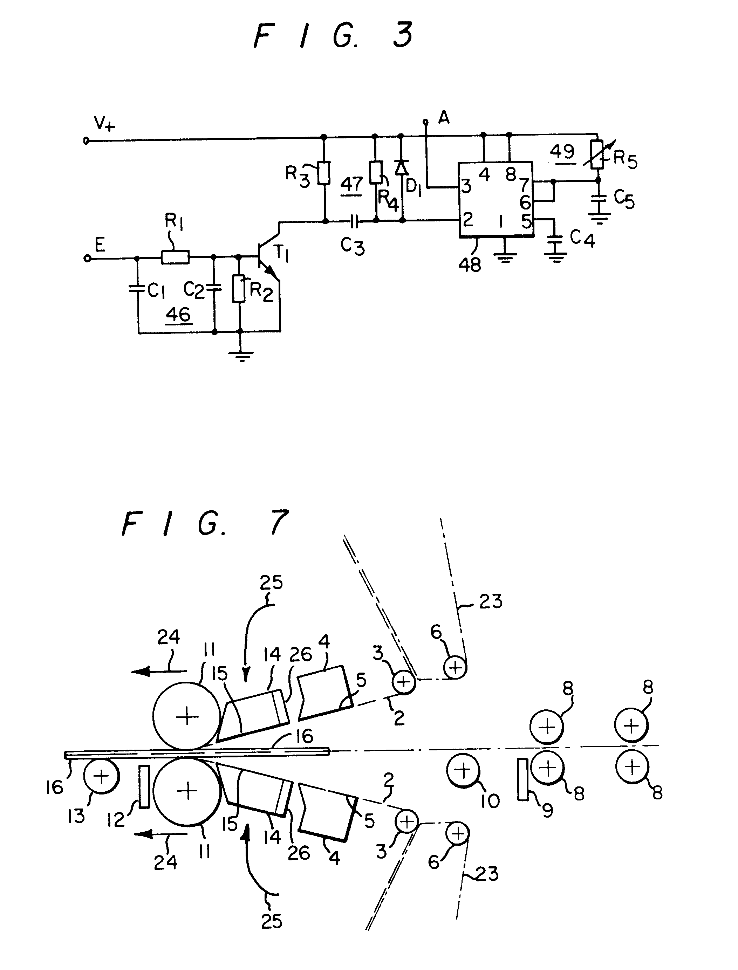

Figure 3 shows a detailed circuit diagram of the control circuit illustrated in Figure 2. The input E is connected with an input step 46, which serves for control voltage delivered for the decushioning of switch 40 (see Figure 1). The input stage consists of resistances $R_1$ and $R_2$, which, as voltage dividers, adapt the input signal for driving a transistor switch $T_1$. A condenser $C_1$ is connected between the input E and ground, and a second condenser $C_2$ is connected between the base of the transistor $T_1$ and ground. The shown circuit of the resistances and condensers gives the input stage 46 deep-pass behavior and assures a positive release of the switch 40.

The output signal of the circuit transistor $T_1$, the emitter of which must be connected to ground, is taken at its collector and is applied to an input terminal 2 of a timing circuit 48, via a pulse forming stage 47 with high-pass behavior formed from resistances $R_3$ and $R_4$, a condenser $C_3$ and a diode $D_1$. The pulse forming stage serves to convert the stage signal delivered from transistor $T_1$ to a signal pulse. Diode $D_1$ makes possible discharging of the condenser $C_3$ on locking the transistor $T_1$ after the switching process. The timing circuit 48 is a commercially obtainable timing circuit of known type ME 555. Its terminals 4 and 8 receive supply voltage, terminal 1 is connected directly to ground and terminal 5 via a condenser $C_4$. The terminals 6 and 7 are connected with an RC member 49 for time advance, which consists of a

variable resistance $R_5$ and a condenser $C_5$. The time constant of the RC member can be adjusted by changing the variable resistance $R_5$. The timing circuit 48, after receiving the control pulse at the input terminal 2 for a time determined by the RC member 49, gives the control voltage at the output terminal 3 to the output A.

In the example described the film being separated has a thickness of a total of about 65-100 micrometers. The diameter of the hot wire amounts to 0.2 mm. its length is 660 mm and the heating voltage is ca. 160 V eff. The heating current is switched on for a time of 80 ms. The amount of energy converted in the heating wire by the heating current pulse amounts to about 100 joules. The final temperature of the hot wire in the heating process is above 1000°C.

Tests have shown that as fast as possible heating up of the hot wire is decisive; the heating power must be located above the value permissible for continuous heating. The necessary heating power increases quadratically with the diameter of the heating wire. so that the thinnest possible heating wire is to be used. However, heating wires with small diameter are less strong. so that, depending on the conditions of use. a lower limit for the heating wire diameter results for practice.

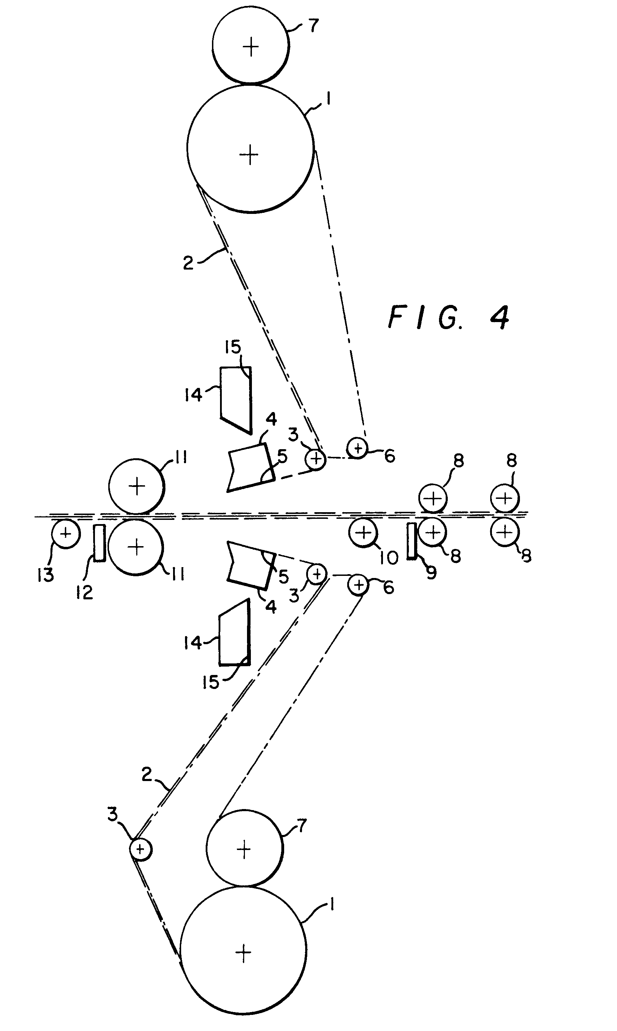

Figure 4 shows an arrangement for rolling dry resist film on printed circuit boards. The film 2 being applied consists of a dry resist film introduced between two protecting films. located on a storage roll 1. The resist film 2 is fed to a handling shoe 4 via deflecting rolls 3. which has a surface 5 turned toward the film with vacuum channels for holding the film. For feeding the film 2 to the handling shoe 4, the protecting film is pulled off on one side by means of the deflecting rolls 6 and a wind-up roll 7. Serving for feeding and preheating the circuit boards a set of laminating rolls 11 is used. A second position sensor 12 serves to determine the location of the coated circuit boards, and additional transporting rolls 13, all of which are not shown, guide the coated circuit boards out of the apparatus. During the laminating process, the resist film is separated piece-wise from the roll supply and is provided with a set of holding shoes 14, which likewise are equipped with suction channels on one face 15, which serve to hold the resist film during the process of separation from the roll storage.

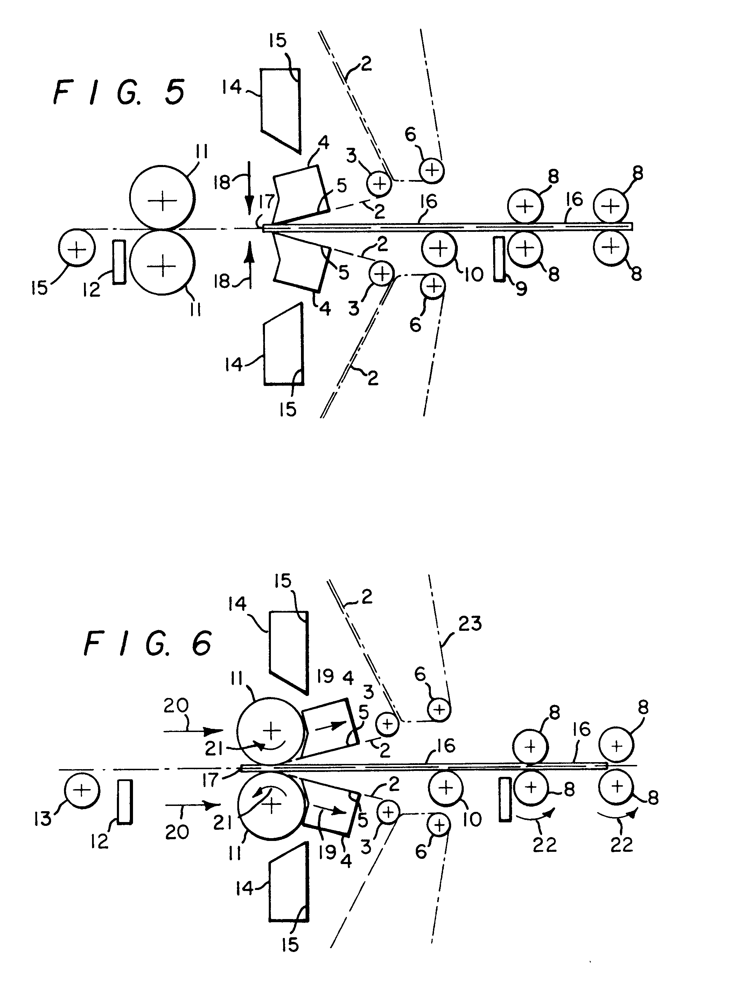

By means of an enlarged section, Figure 5 shows a first operating step of the arrangement shown in Figure 4. A circuit board 16 is introduced in the arrangement so far that its front end 17 protrudes slightly beyond the holding shoe 4. The holding shoes 4, with the resist film 2 held thereon by suction, are driven on the circuit board, as indicated by vertical arrows 18, so far that they adhere on the surface of the resist film near the front edge 17 of the circuit board.

Figure 6 shows an operating step following the adhering of resist film. The holding shoes 4, after switching off the holding vacuum, are driven by a slight distance from the holding place, which is indicated by the arrows 19. The heated laminating rolls 11, are driven to the place at which the resist film 2 is attached to the circuit board 16, so that they contact the resist film adhering to both sides of the circuit board. The movement of the laminating rolls is indicated by arrows 20. The laminating rolls are set in rotation, as indicated by arrows 21, so that they pass the circuit board between them, thereby pull the resist film fed via the deflecting rolls 3 to the surface of the circuit board and there press on continuously. The protecting film 23, pulled off continuously further in the laminating process, reaches the wind-up rolls 7 (not shown) via the deflecting roll 6.

Figure 7 shows the cutting off of the resist film 2 shortly before the end of the laminating process. The circuit board 16 is pressed forward further between the laminating rolls, which have returned to their starting position, as indicated by arrows 24. The holding shoes 14 are driven into the free space between the holding shoes 4 and the laminating rolls 11, so that their vacuum holding surface 15 contacts the resist film 2. The insertion of the holding shoe 14 is indicated by arrows 25. The holding vacuum on the suction surface of the holding shoe 14 is switched on, and the laminating rolls stand still. A hot-wire cutting arrangement 26 of the type shown in Figure 1 is located on each holding shoe 14, the hot wire of which is arranged perpendicular to the plane of the paper of Figure 7 above and below the resist film. The cutting arrangements 26 are activated during stoppage of the laminating rolls, so that the heating wire is applied cold to the resist film 2, and heated up to separate the resist film and, after the separation, are returned to the starting position.

After separating the resist film 2 and switching off the holding vacuum on the holding shoes 14, the laminating rolls 11 are again placed in rotation, so that the rest of the piece of film cut off is rolled onto the circuit board 16. The coated circuit board finally leaves the laminating arrangement via the transport rolls 13, after which the arrangement is prepared for the next laminating process through repositioning its individual elements.

13

WHAT IS CLAIMED IS: AX-0139

1. Process for the thermal separation of a multilayer film containing at least two layers by means of a hot wire, whereby a wire to be heated is placed on the film in a cold state and a current is applied to flow through the wire to produce heat in the wire placed in contact with the film, characterized in that heating current for separating the film is produced without simultaneously joining the layers with one another as a current pulse with a current strength is produced such that during the period of the current pulse the heating power converted in the heated wire is greater than the greatest heating power permissible with continuous heating, and that the duration of the current pulse is limited in such a way that the heated wire is heated sufficiently to evaporate the film material, without fusing the film layers.

2. Process according to Claim 1, characterized in that the heating current is produced as alternating current and is switched on substantially for a duration of a whole-numbered multiple of its half-period duration.

3. Process according to claim 1, characterized in the film comprising a support layer and a photoresist layer.

4. Apparatus comprising a support for a film containing at least two layers, a support for a wire, heating means for the wire and a triggering arrangement for producing heating current which allow heating current to be produced as alternating current and switched off after passage of a whole-numbered multiple of its half-period duration.

5. Apparatus according to Claim 4, characterized in that the triggering arrangement has

14

a no-voltage switch for switching an alternating current on a heating wire which releases the current flow through the heating wire in crossover of the alternating voltage.

6. Apparatus according to Claim 4 characterized in that the triggering arrangement has a time setting arrangement for setting the length of the pulse.

7. Apparatus according to Claim 4, characterized in that the triggering arrangement has a power setting arrangement for setting the heating power.

# F I G. 1

# F I G. 2

0225570

# F I G. 3

# F I G. 7

F I G. 4

FIG. 5

FIG. 6

0225570